# EUROPÄISCHE PATENTSCHRIFT

(11) **EP 1 810 381 B1**
(45) Veröffentlichungstag und Bekanntmachung des Hinweises auf die Patenterteilung: **08.07.2009**
(21) Anmeldenummer: 05810669.1
(22) Anmeldetag: 28.10.2005
(51) Int. Cl.: H01S 5/14

(54) **LASERRESONATOR MIT INTERNEM STRAHLTEILER**
LASER RESONATOR COMPRISING AN INTERNAL BEAM DIVIDER
RESONATEUR LASER A SEPARATEUR DE FAISCEAUX INTERNE

(30) Priorität: 29.10.2004 DE 102004053136
(43) Veröffentlichungstag der Anmeldung: 25.07.2007
(73) Patentinhaber: Raab, Volker, 14469 Postdam (DE)
(72) Erfinder: Raab, Volker, 14469 Postdam (DE)
(86) Internationale Anmeldenummer: PCT/DE2005/001959
(87) Internationale Veröffentlichungsnummer: WO 2006/045304

(56) Entgegenhaltungen:
- WO-A-02/21651
- WO-A-98/56087
- WO-A-02/082593
- WO-A-03/084006
- DE-A1- 10 161 076
- DE-C1- 4 228 541
- US-A- 4 426 707
- US-A- 4 831 631
- US-A- 4 873 697
- US-A- 5 046 184

## Beschreibung

### Technischer Hintergrund und Stand der Technik

Jeder Laser besteht aus einem laseraktiven Bereich, englisch als "gain" und deutsch als "Gewinn" oder "Verstärkung" bezeichnet, in dem von außen zugeführte Energie mittels stimulierter Emission in kohärente Strahlung umgewandelt wird. Dazu ist ein Laserresonator notwendig, der dafür sorgt, dass jeweils ein Teil der entstehenden Strahlung wieder in den Verstärkungsbereich zurück geleitet wird und wofür er mindestens ein Rückkoppelelement enthält, typischer weise einen teildurchlässigen Spiegel. Dieser Resonator bestimmt über seine Geometrie und seine Rückkoppeleigenschaften die physikalischen Eigenschaften des Laserlichts, nämlich vor allem das räumliche Profil, die Wellenlängen, die Bandbreite und die Polarisation.

Die dabei erzielbaren Werte hängen unter anderem vom Verstärkungsmaterial und den Resonatoren ab und sind meist reziprok untereinander und mit der erzielbaren Ausgangsleistung korreliert. Verbesserungen einzelner Parameter führen also in der Regel zu Verschlechterungen bei anderen. Generell sind Verluste und nicht nutzbare Emissionen schädlich für die Gesamtqualität.

Von besonderer praktischer Bedeutung sind Halbleiterlaser, da sie sehr klein und preiswert sind, direkt elektrische Energie in Licht umwandeln, einen hohen Wirkungsgrad besitzen und mit etablierten Techniken der Halbleiter-Produktionstechnologie in großen Stückzahlen hergestellt werden können. Der Resonator ist dabei gleich mit integriert, indem reflektive Schichten auf die Endflächen aufgebracht werden und/oder Brechungsindex-Gitter epitaktisch eingebracht sind. Gegenwärtig ist ihre maximale Ausgangsleistung beziehungsweise die erzielbare Leistungsdichte allerdings noch zu gering für viele hochinteressante Anwendungen. Das beruht darauf, dass die Lichterzeugung in Volumina geschieht, die deutlich kleiner als 1 mm³ sind, und deshalb die auftretenden Leistungsdichten bei Erhöhung zu Zerstörung des Bauteils führen würden. Der Ausweg, die Volumina zu vergrößern, stößt schnell an Grenzen, da dann die Modenselektivität des Resonators abnimmt und sich deshalb die Strahlqualität verschlechtert. Auch Ansätze, die Selektivität zu erhöhen, indem das Verstärkungsmaterial substrukturiert wird (DE 43 38 606, DE 36 11 167), hilft nur wenig.

Deshalb wird seit längerem der Weg beschritten, besonders bei Halbleiterlasern die Funktion von Verstärkung und Resonator zu trennen, also ein Halbleiter-Verstärkungsmaterial in einem externen Resonator zu betreiben, was die erzielbaren Leistungsdichten deutlich erhöht. (DE 101 61 076, WO 02/21651, WO 02/082593, WO 98/56087, US 4 426 707, Opt. Lett. 27(3) pp.167-169). All diesen Veröffentlichungen ist gemein, dass die Emission des Halbleiters in zwei Winkelbereiche aufgeteilt wird, deren einer der Rückkopplung dient und deren anderer der Auskopplung.

DE 42 28 541 C1, WO 03/084006 A und US-A-4 873 697 offenbaren Laserquellen bestehend aus:
(a.) einem Verstärkungsbereich, der mindestens zwei unterschiedliche Richtungen besitzt,
(b.) einem Rückkopplungselement," und
(c.) einem Strahlteiler,
   i. der zwei Eingangskanäle besitzt, die optisch mit unterschiedlichen Emissionsrichtungen des Verstärkungsbereichs verbunden sind,
   ii. der zwei Ausgangskanäle besitzt, von denen der erste mit einem der Rückkopplungselemente verbunden ist.

### Problemstellung

Die externen Resonatoren für Hochleistungs-Diodenlaser gemäß dem Stand der Technik nutzen eine bestimmte Emissionsrichtung der vom Verstärkungsmaterial emittierten Strahlung im wesentlichen für die Rückkopplung und einen anderen Winkelbereich im wesentlichen für die Auskopplung. Der Anteil der emittierten Strahlung in die Rückkoppelrichtung ist nicht einstellbar und ist deshalb in der Regel höher oder niedriger als für optimalen Betrieb notwendig. Wenn die in Richtung des Rückkopplungselements emittierte Strahlung zu hoch ist, also oberhalb der Schwelle für Sättigungsverhalten liegt, geht Ausgangsleistung im Nutzlicht verloren. Ist die Strahlung zu niedrig, leiden die Laserparameter wie Strahlqualität und Seitenmodenunterdrückung, ausserdem steigt der Anteil inkohärent emittierten Lichts, die sogenannte ASE (amplified spontaneous emission). In jedem Fall sind die Energieflüsse im Verstärkungsmaterial sehr asymmetrisch zwischen Aus- und Rückkoppelast verteilt. Das Problem besteht also darin, Anordnungen zu finden, die die unterschiedlichen Emissionskanäle möglichst mit wählbaren Teilerverhältnissen, also z.B. gleichmäßig und symmetrisch, behandeln und durch extern wählbare optische Elemente einen einstellbaren Rückkoppelgrad ermöglichen.

### Prinzipielle Lösung

Die Lösung des Problems besteht darin, einen, vorteilhaft sogar justierbaren, Mischer zwischen den zwei oder mehr verschiedenen Laserkanälen einzubringen. Dies geschieht, indem zwischen dem Verstärkungsmaterial und dem Rückkopplungselement ein oder mehrere Strahlteiler eingesetzt werden, die unterschiedliche Emissionskanäle des Verstärkungsmaterials gleichzeitig mit Anteilen des Rückkoppellichts versorgen können. Dadurch dass diese Strahlteiler wählbare Teilerverhältnisse besitzen, lässt sich die anteilige Leistung in den verschiedenen Emissionskanälen einstellen. Da es mindestens ein frei wählbares Rückkoppelelement gibt, das mehrere Emissionskanäle bedient, ist die optimale Gesamt-Rückkopplung ebenfalls wählbar.

Im Unterschied zum Stand der Technik mit resonatorinternen Strahlteileren wird der Strahlteiler hier so eingesetzt, dass seine Ein- und Ausgangskanäle die Emissionsrichtungen nicht direkt, sondern nur indirekt über das Rückkoppelelement verbinden.

Folgende fundamentale Unterschiede existieren:
- Der Strahlteiler wird so eingesetzt, dass er Licht mehrerer Emissionsrichtungen zum Rückkoppelelement weiterleitet, mindestens jeweils teilweise.
- Bei den hier vorgeschlagenen Anordnungen handelt es sich nicht um Ringresonatoren im eigentlichen Sinne. Ringresonatoren werden vor allem dann eingesetzt, wenn laufende Wellen im Verstärkungsmaterial gewünscht sind, um Lochbrennen zu verhindern. Es sind Maßnahmen (Faraday-Isolatoren, Strahlteiler-Rückkopplung wie in (1), Polarisations-Verluste, etc.) zu ergreifen, die eine Umlaufrichtung/Emissionsrichtung möglichst vollständig unterdrücken. Hier ist das Gegenteil gewünscht: es sollen ausdrücklich beide Emissionsrichtungen aktiv sein. Es handelt sich in ihrem Wesen also nach wie vor um eine Art von linearem Laserresonator mit mehreren Armen, bei dem allerdings die Arme mittels eines Strahlteilers gemischt werden, um die relativen Anteile einstellen zu können. Für viele Ausformungen ist eine möglichst symmetrische Emission zweckmäßig. Diese kann hier eingestellt werden.
- Der Strahlteiler ist hier so eingesetzt, dass beide Emissionsrichtungen ausschließlich zum hilfsweisen Auskoppelkanal oder zum Rückkoppelelement weitergeleitet werden. Kein Teil des vom Verstärkungsmediums ausgehenden Lichts sollte ohne erneute Passage des Rückkoppelelements und des Strahlteilers direkt zurück zum Verstärkungsbereich gelangen, wenn optimale Rückkopplung durch die hier beschriebene Anordnung angestrebt wird.
- Licht, das vom Rückkoppelelement zum Strahlteiler läuft, wird auf beide Emissionsrichtungen aufgeteilt, egal von welcher Emissionsrichtung es ursprünglich kam. Dies ist insbesondere bei Anordnungen mit Polarisationsstrahlteiler in aller Regel nicht der Fall, da die Polarisation üblicher weise dazu genutzt wird, eine eindeutige Richtung vorzugeben.
- Ohne Strahlteiler und Rückkoppelelement gäbe es in den hier vorgeschlagenen Anordnungen keinerlei Lasertätigkeit. Im Stand der Technik dient das zusätzliche Rückkoppelelement gemeinsam mit dem Strahlteiler lediglich der Bevorzugung einer Umlaufrichtung des Ringresonators. Die Verbindung von Eingangs- und Ausgangskanälen des Strahlteilers mit den unterschiedlichen Emissionskanälen des Verstärkungsmediums ist im Stand der Technik vertauscht.
- Im Gegensatz zum Stand der Technik dient der Strahlteiler hier nicht nur der Auskopplung des Nutz- oder Diagnoselichts von Ringresonatoren, sondern er bestimmt die relative Stärke der Umlaufrichtungen.

### Detailierte Beschreibung der Erfindung

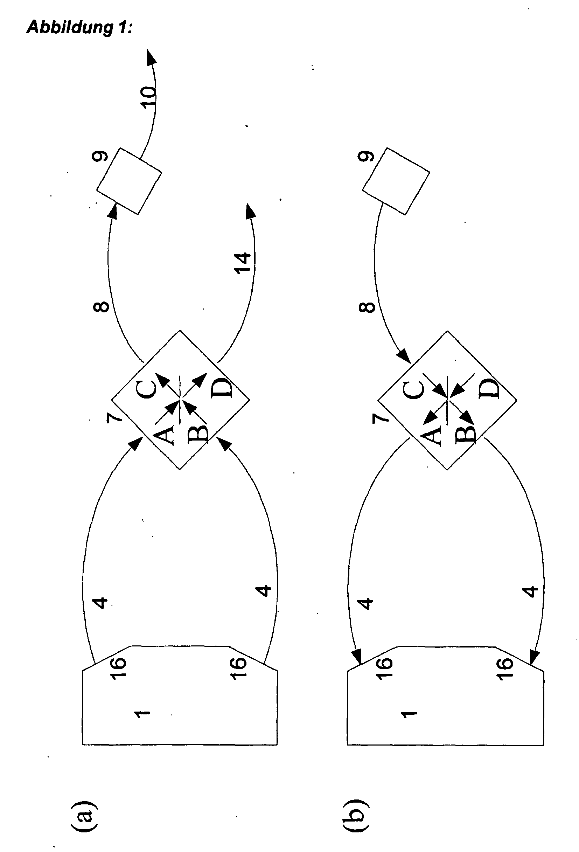

Eine prinzipielle Darstellung der Funktionsweise des Laserresonators ist in Abbildung 1 als Blockdiagramm dargestellt, in Bildteil (a) der Lichtweg vom Verstärkungsbereich 1 zum Rückkoppelelement 9 und in Bildteil (b) der Rückweg. Das Verstärkungsmaterial ist dabei lediglich durch seine Fähigkeit charakterisiert, mit stimulierter Emission auf Rückkopplung zu reagieren. Es kann sich um Anordnungen mit und ohne eigene Resonatoren handeln. Somit wird hier keine Unterscheidung getroffen zwischen extern zu Resonanz gezwungenen (engl.: "seeding") Anordnungen, die manchmal auch als regenerativer Verstärker bezeichnet werden, und solchen Anordnungen, bei denen die Resonatoren erst durch die extern hinzugefügte Rückkopplung vollständig werden. Wenn im Folgenden überhaupt eine Unterscheidung gemacht wird, so wird im ersten Fall von "Lasern" geredet und im zweiten von "halboffenen Lasern", um deutlich zu machen, dass ihnen noch einseitig eine Rückkopplung fehlt. Ein laseraktiver Verstärkungsbereich 1 besitzt mindestens eine Fläche 16, durch die insgesamt mindestens zwei verschiedene Strahlen 4 ein- und auskoppeln können. Für die Funktion ist dabei unwesentlich, ob die beiden Strahlen zwei "wirkliche" Strahlen sind, oder ob es sich um zwei Winkelbereiche eines einzelnen breiten Strahls handelt, zumal in vielen realen Situationen eine Unterscheidung kaum möglich ist. Zentrales Element des Laserresonators gemäß der Erfindung ist der Strahlteiler 7, der in Bildteil (a) zwei Eingangssignale A und B in zwei Ausgangssignale C und D mischt und in Bildteil (b) ein einzelnes Rückkoppelsignal 8 in Kanal C auf zwei Rückkoppelkanäle A und B aufteilt. Bei geeigneten Eingangssignalen A und B kann der Strahlteiler so gewählt werden, dass einer der beiden Ausgangskanäle, vorzugsweise D, keine Leistung trägt. In diesem Fall ist die gesamte Leistung, die vom Verstärkungsmaterial 1 in zwei Kanäle 4 emittiert wird, in einem einzigen Strahl 8 enthalten. Eine Rück- und Auskopplung des Nutzlichts 10 ist über ein Element 9, vorzugsweise ein teilreflektiver Spiegel oder Gitter, zu realisieren. Aufgrund der Symmetrie optischer Strahlteiler kehrt sich in Bildteil (b) für das Rückkoppellicht die Funktion der Kanäle A/B und C/D um, so dass das über C einfallende Licht entsprechend dem Teilerverhältnis auf A und B verteilt wird und zum Verstärkungsbereich 1 zurück kehrt, wo es zur stimulierten Emission beiträgt.

Beim Strahlteiler 7 handelt es sich vorteilhaft um ein teilreflektierendes Element (z.B. Spiegel, Gitter, Polarisations-Strahlteiler, diffraktive Optik, holographisches Element, etc.) der Reflektivität R und Transmission T=1-R. Wenn dieser von einem Strahl A der Feldstärke E_{A} beschienen wird, entstehen zwei Teilstrahlen C und D mit den Feldstärken E_{C} = a_{CA}*E_{A} und E_{D} = a_{DA}*E_{A}. Entsprechend entstehen aus einem Teilstrahl B der Feldstärke E_{B} zwei Teilstrahlen C und D mit E_{C} = a_{CB}*E_{B} und E_{D} = a_{DA}*E_{A}. Die Koeffizienten a_{CA}, a_{DA}, a_{CB} und a_{DB} sind dabei die Elemente einer unitären Matrix, die die Absolutbeträge SQRT(R) und SQRT(1-R) und geeignete Phasen besitzen, um die Energieerhaltung zu berücksichtigen. Die jeweils beiden Strahlen E_{C} = a_{CA}*E_{A} und E_{C} = a_{CB}*E_{B} bzw. E_{D} = a_{DA}*E_{A} und E_{D} = a_{DB}*E_{B} müssen miteinander interferieren, wodurch sich konstruktive oder destruktive Effekte ergeben, so dass sich die relativen Leistungsanteile ändern.

Besonders interessant sind einige Spezialfälle und darunter insbesondere der mit gleichen Intensitäten und Phasenlagen in beiden Strahlen 4 und einem Teilerverhältnis von R=T=50%, also Koeffizienten a_{CA}= a_{DA}= a_{CB} = -a_{DB} = 1/SQRT(2). Dann ist tatsächlich erfüllt, dass keine Leistung im Strahl D auftritt. Auch das Licht, das vom Element 9 zurück kehrt, wird wieder in zwei gleiche intensive Rückkoppelstrahlen A und B aufgeteilt. Wenn das Verstärkungselement 1 symmetrisch ist, bleiben beide Strahlen 4 gleich intensiv und ohne relative Phasendifferenz. In diesem Fall wird das Nutzlicht vorteilhafter weise über das Rückkoppelelement 9 ausgekoppelt. Der Auskoppelgrad kann dann im Prinzip frei gewählt werden.

Dieses Verhalten bleibt im wesentlichen auch dann erhalten, wenn die Reflektivität nicht sehr stark von 50% abweicht. Dann ergibt sich ein schwacher Zusatzstrahl 14, der sich z.B. für diagnostische Zwecke einsetzen lässt.

Wenn die Reflektivität des Strahlteilers deutlich von 50% abweicht, tritt eine Asymmetrie in den Rückkoppelintensitäten auf. Wird diese durch das Verstärkungselement zwischen den beiden Strahlen ausgetauscht, so ergibt sich ein relativer Leistungsanteil von 2*R*T im resultierenden Rückkopplungslicht 8 und ein Anteil von (T-R)² im Strahl 14. Vorteilhafter weise wird man dann das Rückkoppelelement 9 möglichst hochreflektiv machen und das Licht im Kanal 14 als Nutzlicht auskoppeln.

In typischen realen Anordnungen werden zudem noch optische Elemente wie Linsen, Spiegel, Prismen und dergleichen zur Kollimation, Abbildung, Strahlführung etc. benötigt, die hier der Übersichtlichkeit wegen nicht dargestellt sind und die insbesondere für die transversalen Eigenschaften des Lichts (Strahltaillen, Divergenzen, Stabilität, etc.) sorgen.

### Erzielte Vorteile

Durch Lösung der genannten Probleme lässt sich eine Kombination aus insgesamt verbesserter Ausgangsleistung und räumlicher und/oder spektraler Strahlqualität erzielen.

Diese Vorteile lassen sich erreichen, ohne dass die Resonatoren nennenswert komplizierter werden. So werden Anordnungen vorgestellt, die weiterhin mit lediglich drei optischen Komponenten (Laserchip, Kollimationslinse, Rückkoppelprisma) auskommen.

Insbesondere die Symmetrisierung der Emissionskanäle ist vorteilhaft, wenn wegen hoher Verstärkung des Verstärkungsmediums auch hohe Auskoppelgrade realisiert sind. Anderenfalls erhöhen sich der Anteil verstärkter spontaner Emission (ASE, engl: "amplified spontaneous emission") und die Gefahr, dass unerwünschte Lasermoden anschwingen.

In den vorgeschlagenen Anordnungen findet vorzugsweise kein direkter Austausch von Strahlung zwischen den verschiedenen Emissionskanälen statt, sondern nur indirekter Austausch nach Passage des Strahlteilers und des Rückkoppelelements, das vorteilhaft auch als Auskoppelelement ausgeführt ist. Dadurch wird vermieden, dass eine Lasermode anschwingt, die nur deshalb die höchste Verstärkung besitzt, weil sie keine Auskopplungsverluste erleidet.

Insbesondere bei Halbleiterlasern und dort speziell bei solchen mit substrukturiertem Verstärkungsbereich (DE 43 38 606, DE 36 11 167) sind solche Anordnungen vorteilhaft, da diese bekanntermaßen mehrere bevorzugte Emissionsrichtungen besitzen.

Auch bei optisch gepumpten Lasern sind diese Anordnungen vorteilhaft, da eine Pumpanordnung aus mehreren kohärenten Strahlen zu Interferenzmustern, also periodischen Modulationen, der Verstärkung führt. Dadurch ergeben sich ganz natürlich mehrere, ebenfalls durch Interferenz-Bedingungen bestimmte, Emissionsrichtungen des entstehenden Laserlichts, die dann gemäß der vorgeschlagenen Anordnungen behandelt werden können. So lässt sich durch eine Kombination aus Pumpanordnung und Laserresonator eine deutlich verbesserte Modenkontrolle erreichen.

Bei Festkörperlasern kann die Asymmetrie eliminiert werden, die dadurch entsteht, dass typischer weise auf der einen Seite lediglich ein hochreflektives Rückkoppelelement eingesetzt wird und auf der anderen Seite die Auskopplung geschieht. Eine beidseitige Auskopplung erhöht die mittlere Feldstärke über die Länge des Verstärkungsmaterials und verbessert dadurch die Effizienz und spektralen Eigenschaften.

Die entwickelten Anordnungen sind für eine große Zahl unterschiedlicher Laser und Lasertypen anwendbar, unabhängig vom Verstärkungsmaterial. Insbesondere sind auch Anordnungen mit mehreren und gegebenenfalls gekoppelten Lasern denkbar.

### Ausführungsbeispiele

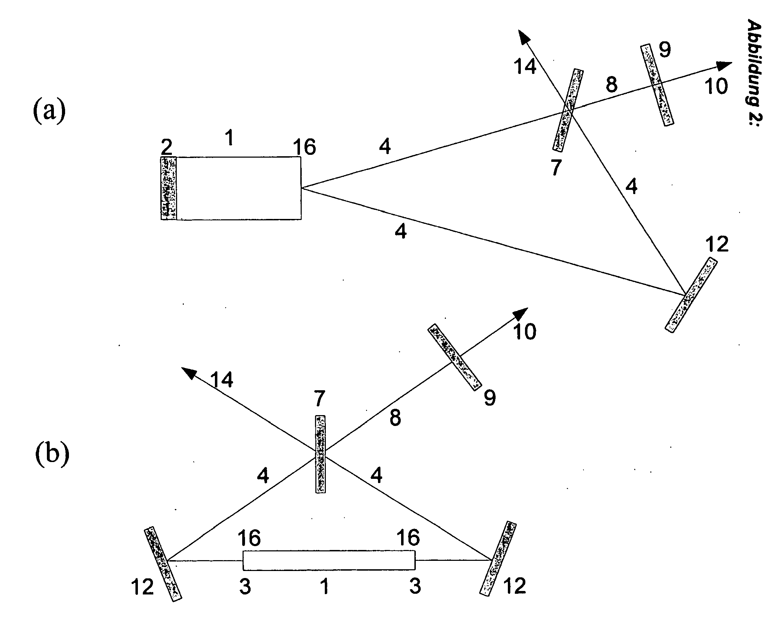

In Abbildung 2 sind zwei verschiedene einfache Ausführungsbeispiele dargestellt. In Bildteil (a) ist eine Anordnung gezeigt, die sich z.B. für Hochleistungs-Halbleiterlaser eignet. Der Verstärkungsbereich 1, der dabei rückseitig vorteilhaft mit einer reflektiven Schicht 2 als Rückkoppelelement versehen ist, emittiert zwei Strahlen 4 unter verschiedenen Winkeln durch seine Austrittsfläche 16. Ein Strahl wird von einem Umlenkspiegel 12 abgelenkt. Diese beiden Strahlen treffen von beiden Seiten auf einen Strahlteiler 7, hier ein teilreflektierender Spiegel. Dabei sind die Auftreffwinkel so gewählt, dass der reflektierte Strahl des einen und der transmittierte Strahl des anderen möglichst gut übereinander liegen und somit gemeinsam den Strahl 8 bilden. Dieser trifft auf den Rückkoppelspiegel 9, der möglicher weise teildurchlässig ist. Abhängig von allen Komponenten wird möglicher weise ein zusätzlicher Strahl 14 auftreten oder auch nicht. Dem entsprechend kann das Nutzlicht aus dem Strahl 10 und/oder dem Strahl 14 bestehen und/oder an weiteren Stellen mittels zusätzlicher Auskoppelelemente gewonnen werden. In Bildteil (b) ist eine mögliche Anordnung für Festkörperlaser angedeutet, in dem die beiden aus den Facetten 16 austretenden Strahlen vorteilhaft jeweils von Spiegeln 12, die vorteilhaft gekrümmt sind, zum Strahlteiler 7 geleitet werden.

Es ist vorteilhaft, wenn die optischen Wege vom Verstärkungsbereich zum Strahlteiler gleich lang sind, oder zumindest die Strahlparameter (insbesondere Strahldurchmesser, Rayleigh-Länge, Divergenz, Strahlqualität) für beide identisch sind. Das verbessert die Qualität, mit der die Strahlen interferieren können. Anderenfalls sind die Strahlparameter der beiden vom Strahlteiler abgehenden Strahlen unterschiedlich, was in der Anwendung berücksichtigt werden sollte.

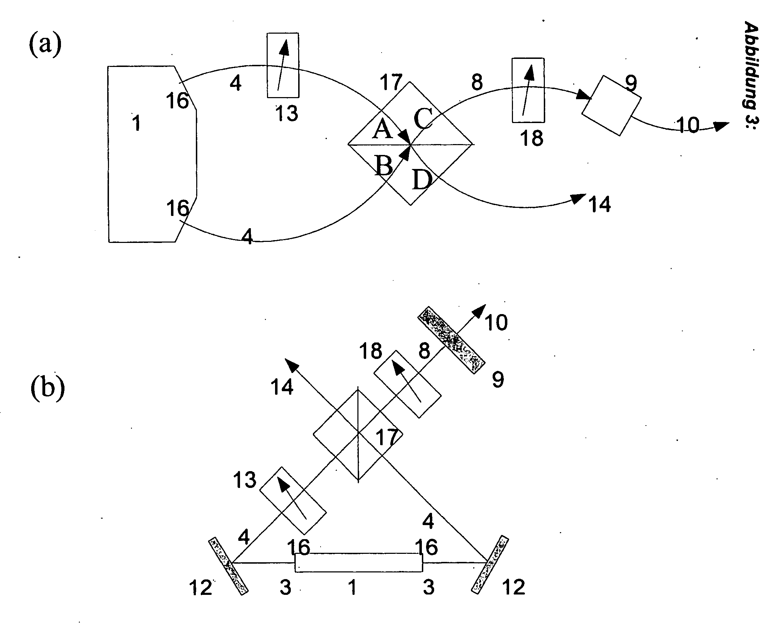

Eine Anordnung, in der das Teilerverhältnis einfach einstellbar ist, ist in Abbildung 3 dargestellt, in Bildteil (a) das Prinzip, in Bildteil (b) eine mögliche Ausgestaltung. Hier ist der Strahlteiler 17 als polarisationsabhängiger Strahlteiler angenommen. Teilerverhältnisse und Rückkoppelgrad lassen sich durch die relative Rotation der Verzögerungselemente 13 und 18 bezüglich der Orientierung des Strahlteilers steuern.

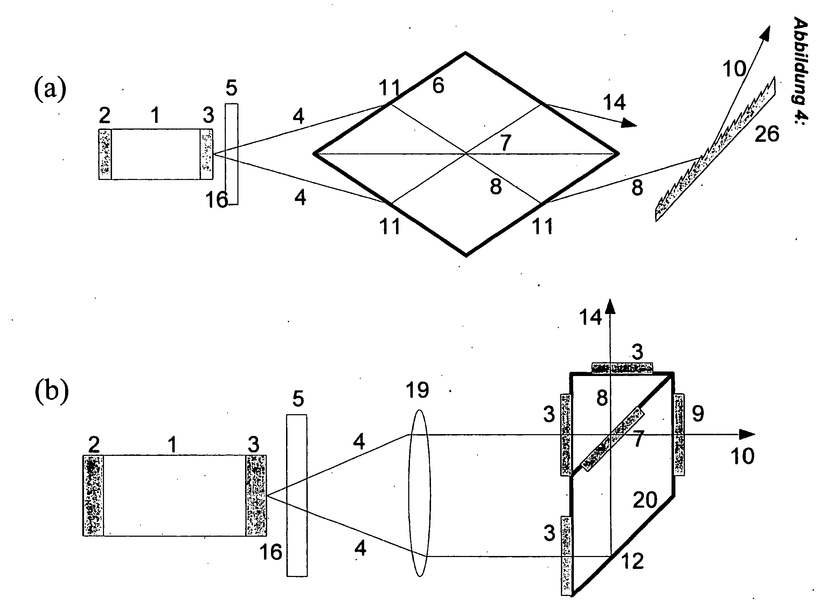

Abbildung 4 zeigt zwei bevorzugte Anordnungen für Halbleiterlaser. Das aktive Medium 1 emittiert zwei Strahlen 4, die an einem Strahlteiler 7 zu einem einzigen Strahl 8 vereinigt werden. Rück- und Auskopplung geschieht in Bildteil (a) über ein Element 26 und in Bildteil (b) über ein Element 9, so dass das Nutzlicht 10 und 14 zur Verfügung steht. In Bild (a) ist die Rückkopplung mittels eines Gitters in Littrow-Anordnung realisiert, so dass eine Auskopplung über die nullte Beugungsordnung geschehen kann. Vorteilhaft werden Kollimatoren 5, Antireflex-Beschichtungen 3 und 11 sowie Umlenkspiegel 12 hinzugefügt. Vorzugsweise wird das Gitter so angebracht, dass seine Wellenlängenselektivität längs der fast-axis (Richtung großer Divergenz, senkrecht zur Ebene der Epitaxie) geschieht, da dann die Kombination aus Gitter und Fast-Axis-Kollimator 5 als ein starkes Frequenzfilter wirkt. Vorteilhaft wird die antireflektive Eigenschaft 11 erreicht, indem die Brewster-Bedingung erfüllt wird. In Bildteil (b) ist die Anordnung um eine Kollimationslinse 19, die die Strahlen längs der sogenannten slow-axis (Richtung geringerer Divergenz, parallel zur Ebene der Epitaxie) kollimiert und ablenkt, ergänzt. Ausserdem wurden alle Spiegel 7, 9 und 12 monolithisch in ein Element 20 integriert, das vorteilhaft antireflektiv mit Schichten 3 versehen wird.

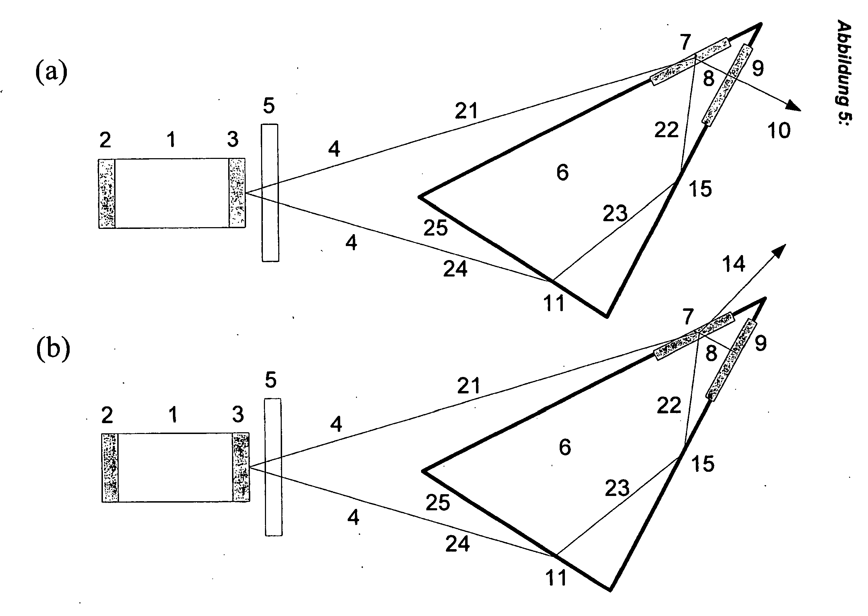

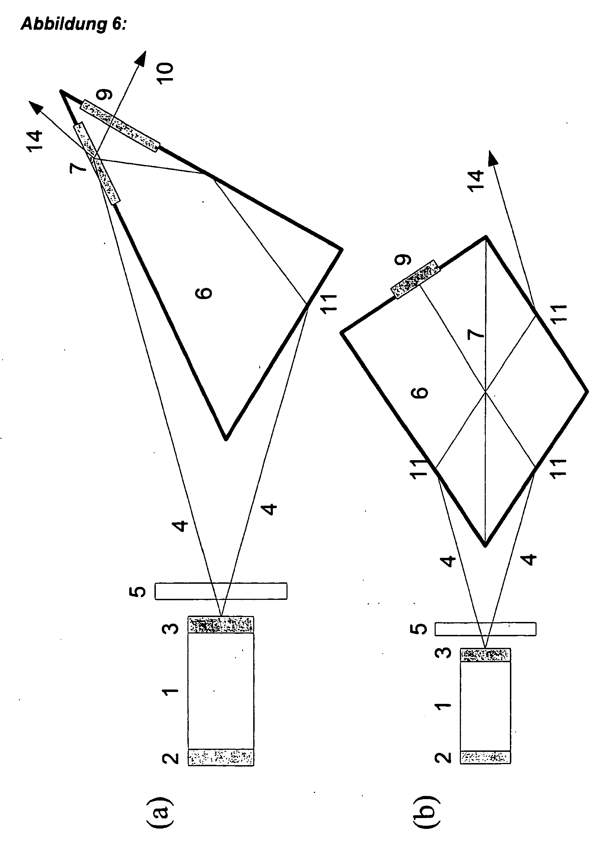

In Abbildung 5 ist die Verwendung eines an die Emissionswinkel des Verstärkungsbereichs angepassten Prismas dargestellt. Der Unterschied zwischen Bildteil (a) und (b) besteht darin, dass in (a) durch das Rückkoppelelement 9 und in (b) über den Strahlteiler 7 ausgekoppelt wird. Dies ist erreichbar durch geeignete Wahl der Reflektivitäten der beiden Spiegel entsprechend der oben angegebenen Überlegungen. Der Rest des Strahlverlaufs ist in beiden Fällen gleich: Das in zwei Richtungen aus dem mit Spiegel 2 und Antireflexschicht 3 versehenen Verstärkungsmaterial 1 austretende Licht 4 wird vorteilhaft mittels einer Linse 5, z.B. einem FAC (fast axis collimator) kollimiert. Bedingung an die korrekte Funktion ist das senkrechte Auftreffen des Lichts auf das Rückkoppelelement 9. Der Winkel zwischen Strahlteilerfläche 7 und Element 9 bestimmt dann abhängig vom Brechungsindex des Prismas den Ablenkwinkel unter dem sich der direkt zum Verstärkungsbereich verlaufende Strahl 21 bewegt, sowie die Winkel der Strahlen 22 und 23. Durch Variation des Winkels der verbleibenden Prismenseite 25 lässt sich dann der Winkel des Strahls 24 in bestimmten Grenzen beeinflussen und an den vom Verstärkungsbereich vorgegebenen Winkel zwischen den beiden Strahlen 4 anpassen. Möchte man, dass der Durchgang durch Fläche 25 unter Brewster-Bedingung geschieht, um die Antireflex-Beschichtung 11 zu sparen, so ergibt sich daraus eine zusätzliche Bedingung an den Winkel zwischen 7 und 9, womit das Prisma eindeutig bestimmt ist. Diese Konfiguration lässt sich innerhalb eines bestimmten Winkelbereichs zwischen den Strahlen 4 anpassen. Für andere Winkelbereiche sind andere Prismen mit mehr oder weniger inneren Totalreflexionen zu wählen. Vorteilhaft an allen Varianten dieser Anordnung ist ihre Einfachheit und die kostengünstige Produzierbarkeit. Diese beruhen auf der Tatsache, dass außer dem Halbleiter als Verstärkungsmaterial 1 lediglich eine Kollimationslinse 5 und ein Prisma 6 mit zwei aufgebrachten (Teil-) Verspiegelungen 7 und 9 notwendig sind, wenn man die Konzepte des instabilen Resonators verwendet. Anderenfalls wird gegebenenfalls noch eine weitere Linse für die Kollimation längs der slow-Richtung notwendig.

Alle genannten Anordnungen sind besonders vorteilhaft in Kombination oder Erweiterung der instabilen Resonatoren von DE 101 61 076. Da als Streifenarray ausgeformte Hochleistungs-Breitstreifenlaser prinzipbedingt zwei Vorzugsrichtungen für ihre Emission besitzen, bieten sich die vorgeschlagenen Anordnungen an. Da ebenso bekannt ist, dass dort instabile Resonatoren gut funktionieren, lassen sich die verbleibenden Probleme, namentlich die nicht kontrollierbaren Leistungsanteile in den beiden Emissionskanälen, durch diese neuen Anordnungen lösen.

### Weitere Ausgestaltung der Erfindung

Die Erfindung lässt sich für beliebige Lasermaterialien einsetzen. Besonders vorteilhaft ist außer Halbleitern alles, was natürlicher weise oder aufgrund der Pumpbedingungen mehrere Emissionskanäle oder eine mehr als zweifach beugungsbegrenzte Divergenz besitzt. Dazu gehören insbesondere optisch gepumpte Verstärkungsmedien, wenn das Pumplicht aus mehreren kohärenten und interferierenden Teilstrahlen besteht.

Die meisten der vorgeschlagenen Anordnungen eignen sich auch für Arrays einzelner Laser. Meist sind dafür nicht einmal einzelne Resonatoren vonnöten, sondern der externe Resonator kann so gestaltet werden, dass alle einzelnen Emitter in einem einzigen gemeinsamen Resonator arbeiten.

Es soll an dieser Stelle nochmals ausdrücklich darauf hingewiesen werden, dass es sich bei den Verstärkungsbereichen um Laser oder um "halboffene" Laser handeln darf. Es spielt also für die Anordnungen nur eine untergeordnete Rolle, ob es auch ohne die hier vorgestellten Resonatoren zu einer Lasertätigkeit des aktiven Bereichs kommen kann oder nicht.

### Kurzbeschreibung der Abbildungen

### Bezeichnungen in Abbildungen:

(1) Verstärkungsmaterial
(2) Rückkoppelelement
(3) Antireflex-Beschichtung
(4) Strahlen, die vom Verstärkungsbereich in mindestens zwei verschiedene Richtungen emittiert werden
(5) Kollimator-Optik
(6) Optik, die die strahlvereinigende Optik aufnimmt
(7) Strahlteiler
(8) Vereinigte Strahlen
(9) Rückkoppelelement
(10) Ausgekoppeltes Licht
(11) Antireflex-Beschichtung, vorzugsweise durch Brewster-Bedingung
(12) Umlenkspiegel
(13) Polarisations-beeinflussendes Element, vorzugsweise doppelbrechende Phasenplatte mit λ/2-Verzögerung
(14) Zusätzlich ausgekoppeltes Licht
(15) Umlenkspiegel durch Totalreflexion
(16) Ein- und Austrittsfläche des Verstärkungsmaterials
(17) Polarisationsabhängiger Strahlteiler
(18) Phasenplatte, vorzugsweise mit λ/4-Verzögerung
(19) Linse
(20) Monolithisches Strahlteiler- und -umlenkelement
(21) Strahl
(22) Strahl
(23) Strahl
(24) Strahl
(25) Seite des Prismas
(26) Rückkoppelelement, vorzugsweise ein Gitter in Littrow-Anordnung

### Abbildung 1:

Prinzip der Erfindung. (a) Ein Verstärkungsbereich 1 emittiert mindestens zwei Strahlen 4, die auf die Eingangskanäle A und B eines Strahlteilers 7 treffen. Einer seiner Ausgangskanäle C emittiert Licht 8 zu einem Rückkoppelelement 2. Typischerweise wird entweder ein Teilstrahl 10 oder ein Teilstrahl 14 als Nutzlicht ausgekoppelt. (b) Das vom Rückkoppelelement kommende Licht 8 in Kanal C wird auf die Kanäle A und B aufgeteilt.

### Abbildung 2:

Einfache Ausführung der Erfindung. Die beiden Strahlen 4, die vom Verstärkungsbereich 1 durch die Fläche 16 treten, werden am Strahlteiler 7 zu zwei Strahlen 8 und 14 rekombiniert. Der eine trifft auf ein Rückkoppelelement 9. Nutzlicht besteht aus den Strahlen 10 und 14. (a) Prinzip und einfachste Ausführung, (b) Variante vorteilhaft für Festkörperlaser, insbesondere bei gekrümmten Spiegeln 12 und/oder 9.

### Abbildung 3:

In einer Anordnung, in der der Strahlteiler 17 polarisations-abhängig wirkt, lassen sich Rückkoppel- und Auskoppelgrad durch die relative Orientierung von Phasenplatten 13 und 18 bezüglich der Vorzugsrichtung des Strahlteilers 17 einfach variieren und dadurch die Intensitäten der Strahlen 10 und 14 beeinflussen.

### Abbildung 4:

Bevorzugte Ausformungen für Halbleiterlaser. (a) Das aktive Medium 1 emittiert zwei Strahlen 4, die an einem Strahlteiler 7 zu einem einzigen Strahl 8 vereinigt werden. Rück- und Auskopplung geschieht über ein Element 26 oder 9, so dass das Nutzlicht 10 zur Verfügung steht. Vorteilhaft werden Kollimatoren 5, Antireflex-Beschichtungen 3 und 11 sowie ein Umlenkspiegel 12 hinzugefügt. Vorteilhaft wird die antireflektive Eigenschaft 3 und/oder 11 erreicht, indem die Brewster-Bedingung erfüllt wird. (b) Ergänzung um Kollimationselement 19 sowie monolithische Integration der Spiegel 7, 9 und 12.

### Abbildung 5:

Bevorzugte, weil besonders einfache, Ausformungen für Halbleiterlaser bestehen darin, ein bezüglich seiner Winkel und Brechungsindexes speziell angepasstes Prisma mit total- oder teilreflektierenden Beschichtungen 7, 9 und 11 zu versehen, so dass das Auftreffen der Strahlung auf die Teilfläche 9 senkrecht geschieht. In Fall (a) ist der Spiegel 9 der Auskoppler für das Nutzlicht 10, in Fall (b) der Spiegel 7 für das Nutzlicht 14.

### Abbildung 6:

(a) Ausformung aus Abbildung 5 mit wahlweiser Nutzung des Lichts 14 oder 9. (b)Alternative Variante mit einem Prisma, das einen inneren Strahlteiler besitzt.

## Patentansprüche

1. Laserquelle bestehend aus:
(a.) mindestens einem Verstärkungsbereich, der mindestens zwei unterschiedliche Emissionskanäle besitzt, durch die er Strahlung emittiert und empfängt,
(b.) mindestens einem Rückkopplungselement,
(c.) mindestens einem resonatorinternen Strahlteiler,
(d.) **gekennzeichnet dadurch, dass** sie mindestens einen resonatorinternen Strahlteiler besitzt,
i. dessen mindestens zwei Eingangskanäle optisch mit unterschiedlichen Emissionskanälen des Verstärkungsbereichs verbunden sind, die jeweils mindestens einen Teil des einfallenden Lichts über einen gemeinsamen Ausgangskanal zu besagtem Rückkopplungselement leiten,
ii. der Licht von besagtem Rückopplungselement mindestens auf diese beiden besagten Emissionskanälen verteilt, unabhängig davon, von welchem Emissionskanal das Licht ursprünglich herrührte
iii.und der damit als Mischer zwischen den beiden Emissionskanälen arbeitet.

2. Laserquelle gemäß Anspruch 1, **gekennzeichnet dadurch, dass** sich mehrere Emissionskanäle **dadurch** ergeben, dass ein physikalischer Parameter im Pump- oder Verstärkungsbereich periodisch moduliert ist.

3. Laserquelle gemäß Anspruch 1, **gekennzeichnet dadurch, dass** die Teilerverhältnisse von Strahlteiler und Rückkoppelelement einer der folgenden Kombinationen entsprechen:
(a.) der Strahlteiler besitzt näherungsweise 50% Teilerverhältnis, das Rückkoppelelement besitzt beliebige Reflektivität,
(b.) der Strahlteiler besitzt ein Teilerverhältnis ungleich 50% und das Rückkoppelelement besitzt sehr hohe Reflektivität bis zu 100%.

4. Laserquelle gemäß Anspruch 1, **gekennzeichnet dadurch, dass**
(a.) die optischen Wege der zwei Emissionskanäle vom Verstärkungsmedium bis zum Strahlteiler gleich lang sind
(b.) und/oder die Strahlparameter beider Strahlen am Strahlteiler möglichst ähnlich sind.

5. Laserquelle gemäß Anspruch 1, dessen Verstärkungsmedium ein Breitstreifen- oder Streifenarray- Halbleiter ist, **gekennzeichnet dadurch, dass** der Resonator in mindestens einer Richtung instabil ist.

6. Laserquelle gemäß Anspruch 1, **gekennzeichnet dadurch, dass** mehrere Funktionen des Resonators (z.B. der Strahlteiler und/oder das Rückkoppelelement und/oder Abschnitte der Strahlführung und -umlenkung) monolithisch ausgeformt sind.

7. Laserquelle gemäß Anspruch 6, **gekennzeichnet dadurch, dass** die Oberflächen des monolithischen Elements
(a.) mit geeigneten reflektierenden Schichten bedeckt sind, die die benötigten Teilerverhältnisse liefern und/oder unter Brewster-Winkel bestrahlt werden
(b.) und/oder geeignet gegen die Strahlrichtung des einfallenden Lichts geneigt sind, um als Strahlumlenker zu wirken.

8. Laserquelle gemäß Anspruch 6 und/oder 7, **gekennzeichnet dadurch, dass** es sich bei dem monolithischen Element um ein Prisma handelt,
(a.) dessen eine Seite als Rückkoppelelement wirkt,
(b.) dessen zweite Seite als Strahlteiler wirkt,
(c.) dessen dritte Seite als Strahlumlenker wirkt.

9. Laserquelle gemäß Anspruch 7, **gekennzeichnet dadurch, dass** es sich bei dem monolithischen Element um ein Prisma handelt,
(a.) das zwei Seiten besitzt, die von jeweils einer Emission des Verstärkungsbereichs unter dem selben Winkel getroffen werden,
(b.) das im Inneren einen Strahlteiler besitzt, der von beiden Emissionen des Verstärkungsbereichs im selben Bereich und unter dem selben Winkel getroffen wird,
(c.) das so geformt ist, dass der vereinigte Strahl aus den beiden Emissionen senkrecht auf eine dritte Fläche auftrifft und diese Fläche als Rückkoppelelement wirkt.

10. Laserquelle, bestehend aus mehreren Einzelquellen gemäß der vorigen Ansprüche mit Überlagerung der einzelnen Strahlen in kohärenter oder inkohärenter Weise oder als spektrales Multiplexing.

## Revendications

1. Une source laser comprenant:
(a) au moins un domaine d'amplification, qui est composé d'au moins deux canaux d'émission différents par lesquels le rayonnement est émis et reçu
(b.) au moins un élément de rétroaction,
(c.) au moins un séparateur de faisceau inclus dans la cavité optique
(d.) **caractérisée en ce que** le séparateur de faisceau de la cavité optique possède
i. au moins deux canaux d'entrée optique liés aux différents faisceaux laser émis par le domaine d'amplification. Chacun des canaux d'entrée dirige une partie de la lumière incidente à travers un canal commun de sortie vers ledit élément de rétroaction.
ii. la lumière dudit élément de rétroaction est distribuée au moins dans les deux canaux d'émission, indépendamment du canal d'émission de la lumière originelle.
iii. et ainsi fait fonction de mélangeur entre les canaux d'entrée et d'émission.

2. La source laser selon la revendication 1, **caractérisée en ce que** plusieurs faisceaux émis résultent d'un paramètre physique périodiquement modulé à l'intérieur du domaine de pompage ou d'amplification.

3. La source laser selon la revendication 1, **caractérisée en ce que** les rapports de séparation du séparateur de faisceau et de l'élément de rétroaction sont combinés de la façon suivante:
(a.) le séparateur de faisceau a un rapport de séparation aux environs de 50% et l'élément de rétroaction a une réflectivité arbitraire.
(b.) le séparateur de faisceau a un rapport de séparation différent de 50% et l'élément de rétroaction a une réflectivité proche de 100%.

4. Une source laser selon la revendication 1, **caractérisée en ce que**
(a) les chemins optiques des deux faisceauxs laser depuis de l'amplificateur jusqu'au séparateur de faisceau sont de longueur égale
(b.) et/ou les paramètre de rayonnement de ces deux rayons laser au niveau du séparateur de faisceau doivent être les plus similaires possible.

5. Une source laser selon la revendication 1, dont l'amplificateur est un semi-conducteur à bande large ou est formé d'une succession de petites bandes, **caractérisée en ce que** la cavité optique a au moins une direction instable.

6. Une source laser selon la revendication 1, **caractérisée en ce que** plusieurs fonctions de la cavité optique, par exemple le séparateur de faisceau, l'élément de rétroaction, une partie de conduction et/ou de déviation du rayon, sont combinés en un élément monolithique.

7. Une source laser selon la revendication 6, **caractérisée en ce que** les surfaces de l'élément monolithique
(a.) sont recouvertes de couches à la réflectivité appropriée qui produisent les rapports de séparation nécessaires et/ou les surfaces de l'élément monolithique sont irradiés avec un angle de type Brewster.
(b.) et /ou sont inclinées vers la direction de rayon incident de façon à réoriente sa direction.

8. Une source laser selon les revendications 6 et/ou 7, **caractérisée en ce que** l'élément monolithique a les caractéristiques d'un prisme,
(a.) dont un coté agit en tant qu'élément de rétroaction,
(b.) dont un deuxième coté agit en tant que séparateur de faisceau.
(c.) et dont un troisième coté agit en tant que déviateur de rayon.

9. Une source laser selon la revendication 7, **caractérisée en ce que** l'élément monolithique a les caractéristiques d'un prisme,
(a.) qui possède deux cotés, atteints chacun avec le même angle d'incidence par les rayons émis par l'amplificateur,
(b) qui contaient un séparateur de faisceau, atteint par les deux rayons émis par l'amplificateur au même endroit et sous le même angle d'incidence,
(c.) qui est ainsi façonné de sorte que le rayon, unifié à partir des deux rayons émis par l'amplificateur, rencontre perpendiculairement un troisième coté qui agit comme élément de rétroaction.

10. Une source laser composée de plusieurs sources uniques conformément aux revendications précédentes par superposition de rayons individuels de manière cohérente ou incohérente ou comme multiplexage spectral.

## Claims

1. A laser resonator comprising:
a.) at least one gain region with at least two different channels of emission through which it emits and receives radiation,
b.) at least one feedback element,
c.) at least one resonator internal beam splitter,
d.) wherein said beam splitter
i. includes at least two input channels optically connected to different emission channels of the at least one gain region and said beam splitter sends at least part of the incident light from said at least two channels through a common output channel towards said feedback element,
ii. distributes light coming from said feedback element at least onto said two input channels of said at least one gain region, irrespective of the emission channel the light originated from,
iii. operates as a mixer element between said emission/reception channels of said gain region.

2. The laser resonator according to claim 1, wherein said at least one gain region contains a periodically modulating physical parameter inside said gain region of the laser material to result in said at least two channels of emission.

3. The laser resonator according to claim 1, wherein the splitting ratio of said mixer element and said feedback element is at least one of the following:
a.) said mixer element has a splitting ratio of about 50:50 and said Feedback element has arbitrary reflectivity,
b.) said mixer element has a splitting ratio substantially differing from a ratio of 50:50 and said feedback element has a high reflectivity up to 100%.

4. The laser resonator according to claim 1, wherein said mixer element has at least one of the following characteristics:
a.) the optical paths of the two channels of emission have substantially the same length,
b.) and the beam parameter of at least two beams arc substantially alike at said mixing element.

5. The laser resonator according to claim 1, wherein
said gain region is at least one of broad area laser and a stripe array, and,
said resonator is unstable in at least one direct ion.

6. The laser resonator according to claim 1, wherein said resonator has an integrated monolithic structure element, and said monolithic integrated element includes a mixer element, a feedback element, and beam propagation means.

7. The laser Resonator according to claim 6, wherein the surfaces of said monolithic structure element have at least one of the following:
a.) said surfaces are covered with reflective layers to deliver predetermined splitting ratios
b.) the surfaces are incident under Brewster angle
c.) the surfaces are inclined suitably with respect to the direction of incidence, to operate as a beam deflector.

8. The laser resonator according to claim 6 or 7, wherein said monolithic element is a prism having the following,
a.) one face for operating as a feedback element,
b.) a second face for operating as a beam splitter, and,
c.) third face for operating as a deflector.

9. The laser resonator according to claim 7, wherein said monolithic element is a prism having the following.
a.) two faces that are hit under identical angles by the light of of two different emissions.
b.) a beam splitter inside said prism, said beam splitter for being hit by said two channels of emissions substantially at the sime spot and substantially under identical angles, and
c.) a third face for operating as a feedback element:, said third face having a shape such that the beam that results from said two channels of emissions hitting said third face results in said third face operating as feedback element under normal incidence.

10. The laser resonator of one of the previous claim, wherein said laser resonator comprises a multitude of laser resonators wherein single laser beams are superimposed by at least one of coherently and incoherently by means of spectral multiplexing.
